(19) Europäisches Patentamt
European Patent Office
Office européen des brevets

(11) **EP 1 829 848 A1**

(12) **EUROPEAN PATENT APPLICATION**
published in accordance with Art. 158(3) EPC

(43) Date of publication:
**05.09.2007 Bulletin 2007/36**

(51) Int Cl.:
***C04B 41/90*** *(2006.01)*       ***H05K 3/12*** *(2006.01)*

(21) Application number: **05816735.4**

(22) Date of filing: **13.12.2005**

(86) International application number:
**PCT/JP2005/022856**

(87) International publication number:
**WO 2006/064793 (22.06.2006 Gazette 2006/25)**

(84) Designated Contracting States:
**DE GB NL**

(30) Priority: **15.12.2004 JP 2004363004**
                 **21.04.2005 JP 2005123616**

(71) Applicant: **TOKUYAMA CORPORATION**
**Shunan-shi, Yamaguchi 745-8648 (JP)**

(72) Inventors:
• **YAMAMOTO, Yasuyuki,**
**c/o TOKUYAMA CORPORATION**
**Shunan-shi,**
**Yamaguchi 745-8648 (JP)**

• **MAEDA, Masakatsu,**
**c/o TOKUYAMA CORPORATION**
**Shunan-shi,**
**Yamaguchi 745-8648 (JP)**
• **GOTOH, Kunihiro,**
**c/o TOKUYAMA CORPORATION**
**Shunan-shi,**
**Yamaguchi 745-8648 (JP)**

(74) Representative: **Matthews, Derek Peter et al**
**Frank B. Dehn & Co.**
**St Bride's House**
**10 Salisbury Square**
**London EC4Y 8JD (GB)**

(54) **METHOD FOR PRODUCING METALLIZED CERAMIC SUBSTRATE**

(57)    The process for producing a metallized ceramic substrate of the present invention comprises a step (A) of preparing a raw material substrate comprising a ceramic substrate which may have on its surface a conductive layer or a conductor paste layer, a step (B) of preparing a metallized ceramic substrate precursor, said step (B) comprising a step of forming a ceramic paste layer on the raw material substrate and a step of forming a conductive paste layer on the ceramic paste layer, and a step (C) of firing the metallized ceramic substrate precursor obtained in the previous step. In the step (B), formation of a ceramic paste layer and formation of a conductive paste layer may be alternately repeated plural times. According to the present invention, running or spreading of the conductive paste is prevented, and a metallized ceramic substrate which has a high degree of freedom of wiring design and high reliability and has a fine metallization pattern can be produced.

Fig.3

**Description**

TECHNICAL FIELD

The present invention relates to a process for producing a metallized ceramic substrate by forming a conductive paste layer on a ceramic substrate and firing the conductive paste layer.

BACKGROUND ART

As a process for producing a metallized ceramic substrate, a co-firing process (simultaneous firing process) or a post firing process (successive firing process) is known.
The co-firing process is a process comprising forming a conductive paste layer on an unfired ceramic substrate precursor that is called a green sheet to prepare a metallized ceramic substrate precursor and firing the precursor. In this process, firing of the green sheet and firing of the conductive paste layer are carried out simultaneously.

The post firing process is a process comprising forming a conductive paste layer on a ceramic substrate obtained by firing a green sheet to prepare a metallized ceramic substrate precursor and firing the precursor. In this process, firing of the green sheet and firing of the conductive paste layer are carried out successively. Regarding the production of a metallized ceramic substrate by the post firing process, various processes are known, and in a patent document 1, an example thereof is disclosed.

Even by any of the above processes, wiring can be prepared on the ceramic substrate, and the substrate obtained by such a process is mainly used as a substrate for mounting an electronic part.
Patent document 1: Japanese Patent Laid-Open Publication No. H08(1996)-239286

DISCLOSURE OF THE INVENTION

PROBLEMS TO BE SOLVED BY THE INVENTION

For substrates on which electronic parts are to be mounted, further enhancement of accuracy and fineness of wiring patterns has been required with miniaturization of the parts to be mounted, but it has become a situation that the conventional production processes cannot meet such requirements sufficiently.
In the case of, for example, wiring formation by the co-firing process, the green sheet is liable to unevenly shrink in the firing, and when a square green sheet is sintered, shrinkage takes place so as to slightly bend the central part of each side inward, though the shrinkage is slight, the substrate is deformed into a shape of a star, so that in the case where many wiring patterns of the same shapes are formed on one green sheet, the shape of a pattern is slightly changed inevitably depending upon the position of the pattern.

On the other hand, in case of wiring formation by the post firing process, a wiring pattern is formed by applying a conductive paste directly onto a ceramic substrate, drying the paste and then firing it. In the baking (firing) of the wiring, the conductive paste layer shrinks in the thickness direction, but shrinkage in the plane direction rarely takes place, and therefore, such a problem of change in the pattern shape depending upon the position as observed in the co-firing process does not occur.

In case of the post firing process, however, even if the conductive paste is applied in accordance with the shape of the desired circuit pattern, the conductive paste sometimes runs or spreads before sintering, and this is an obstacle to promotion of fining of patterns. That is to say, if "running" or "spreading" of the conductive paste occurs, a short circuit sometimes occurs between wirings of the resulting metallized ceramic substrate, and this lowers reliability. In the post firing process, formation of a wiring pattern having a gap (usually also referred to as "space") between the wirings of about 50 $\mu$m is generally the limit.

The present invention is intended to solve such problems associated with the prior art. That is to say, it is an object of the present invention to realize production of a metallized ceramic substrate having a high degree of freedom of wiring design and high reliability and production of a metallized ceramic substrate having a metallization layer of a fine pattern, by preventing running or spreading of a conductive paste in a process for producing a metallized ceramic substrate, which comprises forming a conductive paste layer on a surface of a ceramic substrate and firing the conductive paste layer.

MEANS TO SOLVE THE PROBLEM

The means to solve the above problems, which are provided by the present invention, are as follows.

    (1) A process for producing a metallized ceramic substrate, comprising:

        a step (A) of preparing a raw material substrate comprising a ceramic substrate which may have on its surface a conductive layer or a conductor paste layer,
        a step (B) of preparing a metallized ceramic substrate precursor, comprising a step of forming a ceramic paste layer on the raw material substrate and a step of forming a conductive paste layer on the ceramic paste layer, and
        a step (C) of firing the metallized ceramic substrate precursor obtained in the previous step.

    (2) The process as stated in (1), further comprising a step of forming a ceramic paste layer on a conductive layer of the metallized ceramic substrate obtained in the step (C) and a step of firing the metallized ceramic substrate having on its surface the ceramic paste layer obtained in the above step.

(3) The process as stated in (1) or (2), wherein in the step (B), formation of a ceramic paste layer and formation of a conductive paste layer are alternately repeated plural times.

(4) The process as stated in any one of (1) to (3), wherein the metallized ceramic substrate obtained in the process of any one of (1) to (3) is used as a raw material substrate.

(5) The process as stated in any one of (2) to (4), wherein the ceramic paste layer formed on the conductive paste layer or a conductive layer obtained by firing the conductive paste layer is a ceramic paste layer which covers a part of said base layer and has a thickness of 1 to 2000 $\mu$m.

(6) The process as stated in any one of (1) to (5), wherein the ceramic substrate comprises aluminum nitride.

(7) The process as stated in any one of (1) to (6), wherein the ceramic paste layer comprises an aluminum nitride-based ceramic.

(8) The process as stated in any one of (1) to (7), wherein the conductive paste layer comprises tungsten or molybdenum.

(9) A metallized ceramic substrate obtained by the process of any one of (1) to (8).

(10) A metallized ceramic substrate having a laminated structure comprising at least one conductive layer and at least one sintered ceramic layer on a sintered ceramic substrate, wherein the topmost layer of the laminated structure is a sintered ceramic layer which covers at least a part of a conductive layer that is a layer under the sintered ceramic layer and has a thickness of 1 to 1000 $\mu$m.

(11) A metallized ceramic substrate having a laminated structure comprising at least one conductive layer and at least one sintered ceramic layer on a sintered ceramic substrate, wherein the sintered ceramic layer to form the laminated structure comprises a sintered body of a ceramic of the same kind as that of the ceramic to constitute the sintered ceramic substrate and the mean grain diameter of ceramic grains to constitute the sintered ceramic layer is 10 to 80% of the mean grain diameter of ceramic grains to constitute the sintered ceramic substrate.

The metallized ceramic substrate of (10) or (11) is one embodiment of the metallized ceramic substrate of (9), and any of them can be produced by the production process of the invention. Especially when a ceramic paste prepared by the use of ceramic powders of the same kind as that of ceramic powders used for producing the sintered ceramic substrate, which has a mean grain diameter equivalent to or smaller than that of the ceramic powder used for producing the sintered ceramic substrate, is used in the production process of the invention, the metallized ceramic substrate of (11) is obtained.

In the case where a sintered ceramic substrate is produced by firing a green sheet or in the case where a metallized substrate is produced by a co-firing process, the green sheet shrinks in the firing step, so that ceramic grains in the green sheet are fusion-bonded to one another and grain growth takes place. On the other hand, in the above-stated production process, shrinkage of the raw material substrate (sintered ceramic substrate) does not take place, so that the ceramic grains in the ceramic paste layer formed on the substrate, particularly those in a ceramic paste layer having a thickness of 1 to 50 $\mu$m, are restricted in moving, and sufficient grain growth does not takes place. On this account, the metallized substrate of the invention produced by the above-stated process has a specific structure such that the mean grain diameter of the ceramic grains to constitute the sintered ceramic layer (layer obtained by firing the ceramic paste layer) is 10 to 80% of the mean grain diameter of the ceramic grains to constitute the sintered ceramic substrate, said structure being not observed in a substrate obtained by the conventional post firing process or co-firing process.

Whether the substrate is a substrate obtained by the above-stated process or not can be confirmed by determining a mean grain diameter of ceramic grains in the vicinity of the bonded area to the metallization layer in the metallized ceramic substrate and a mean grain diameter of ceramic grains present in the vicinity of the center of the substrate and examining whether the former is not more than 80% of the latter or not, more definitely, whether the former is not more than 60% of the latter or not.

EFFECT OF THE INVENTION

If the production process of the invention is used, running or spreading of a conductive paste does not occur in the formation of a conductive paste layer on a ceramic substrate. Accordingly, a ceramic metallized substrate having a high degree of freedom of wiring design and high reliability and a ceramic substrate having a highly accurate and fine metallization pattern can be produced.

If the production process of the invention is used, further, shrinkage of a metallization pattern or a ceramic paste layer in the plane direction in the firing step is decreased as compared with that in the co-firing process, and therefore, a metallized ceramic substrate having higher dimensional accuracy can be produced.

BRIEF DESCRIPTION OF THE DRAWINGS

Fig. 1 shows an embodiment of a metallized substrate obtained by the present invention.
Fig. 2 shows an embodiment of a metallized substrate obtained by the present invention.
Fig. 3 shows an embodiment of a metallized substrate obtained by the present invention.

Fig. 4 is a view showing patterns of an aluminum nitride paste layer and a conductive paste layer formed in Example 1.

Fig. 5 is a microphotograph of a T-shaped metallization layer formed on a metallized substrate of Example 1, which is taken by a video microscope.

Fig. 6 is a scanning electron microphotograph of a section of a metallized substrate of Example 1.

Fig. 7 is a scanning electron microphotograph of a section of a metallized substrate of Comparative Example 1.

Fig. 8 is a microphotograph of a T-shaped metallization layer formed on a metallized substrate of comparative Example 1, which is taken by a video microscope.

Description of symbols

| 1: | ceramic substrate |
|---|---|
| 1A, 2A: | ceramic paste layer |
| 1B, 2B: | conductive paste layer |
| 10: | ceramic substrate having conductive layer formed thereon |
| 11: | conductive layer |
| 21: | aluminum nitride paste layer |
| 22: | conductive paste layer |
| 23: | metallization pattern after firing |
| 24: | ceramic paste layer after firing (surface) |
| 25: | ceramic paste layer after firing (section) |
| 26: | raw material substrate (sintered aluminum nitride substrate) (section) |

BEST MODE FOR CARRYING OUT THE INVENTION

The process for producing a metallized ceramic substrate of the invention comprises a step (A) of preparing a raw material substrate comprising a ceramic substrate which may have on its surface a metal layer or a conductor paste layer; a step (B) of preparing a metallized ceramic substrate precursor, which comprises a step of forming a ceramic paste layer on the raw material substrate and a step of forming a conductive paste layer on the ceramic paste layer; and a step (C) of firing the metallized ceramic substrate precursor obtained in the previous step.

In the production process of the invention, first, a raw material substrate comprising a ceramic substrate, which may have on its surface a conductive layer or a conductor paste layer, is prepared in the step (A). As the ceramic substrate used herein, substrates composed of publicly known ceramics are employable without any restriction.

As the ceramic that is a constituent material of the ceramic substrate, there can be used, for example, (i) oxide-based ceramics, such as aluminum oxide-based ceramics, silicon oxide-based ceramics, calcium oxide-based ceramics and magnesium oxide-based ceramics; (ii) nitride-based ceramics, such as aluminum nitride-based ceramics, silicon nitride-based ceramics and boron nitride-based ceramics; and (iii) beryllium oxide, silicon carbide, mullite and borosilicate glass. Of these, the nitride-based ceramics (ii) are preferable, and the aluminum nitride-based ceramics can particularly preferably be employed because they have high thermal conductivity.

As the ceramic substrate for use in the production process of the invention, a sintered ceramic substrate, especially one constituted of ceramic grains having a mean grain diameter of 0.5 to 20 $\mu$m, preferably 1 to 15 $\mu$m, is preferably employed for the reason that such a substrate is easily available and a substrate of a desired shape is easily obtainable. Such a substrate can be obtained by firing a green sheet composed of a ceramic raw material powder having a mean grain diameter of 0.1 to 15 $\mu$m, preferably 0.5 to 5 $\mu$m.

In the green sheet, a sintering auxiliary agent, an organic binder, etc. may be contained. As the sintering auxiliary agent, sintering auxiliary agents which are commonly used according to the types of the ceramic raw material powders are employable without any restriction. As the organic binder, polyvinyl butyral, ethyl celluloses and acrylic resins are employed, and for the reason that moldability of the green sheet becomes excellent, poly-n-butyl methacrylate or polyvinyl butyral is particularly preferably employed.

From the viewpoint of thermal conductivity of the resulting sintered body, it is preferable to use a green sheet for nitride ceramics, which is formed using as the ceramic raw material powder nitride ceramic powders containing a sintering auxiliary agent, particularly a green sheet for aluminum nitride, which is formed using as the raw material powder aluminum nitride powders containing a sintering auxiliary agent (e.g., yttrium oxide or calcium oxide).

The shape of the ceramic substrate for use in the invention is not specifically restricted provided that it has a surface on which a ceramic paste layer and a conductive paste layer can be formed, and a plate, a plate having been partially subjected to cutting or hole opening or a substrate having a curved surface is also employable. The ceramic substrate may have a via hole (i.e., through hole filled with a conductor or a conductive paste) or an inner layer wiring. Such a raw material substrate can be easily produced by, for example, a co-firing process using a green sheet having the above structure.

The size of the raw material substrate is not specifically restricted and has only to be determined according to the use application. For example, when the resulting substrate is used for mounting an electronic part thereon, the thickness of the substrate is selected in the range of generally 0.1 to 2 mm, preferably about 0.2 to 1 mm.

In the production process of the invention, the ceramic substrate may be used as it is as the raw material substrate. It is also possible to use, as the raw material substrate, a metallized substrate having a conductive layer or a conductive paste layer that has been formed in advance on a surface of the above ceramic substrate by a conventional process or a metallized ceramic substrate obtained by the production process of the invention. By the use of the above metallized substrate as the raw material substrate, a conductive layer is made to have multilayer construction, as described later. Consequently, the degree of freedom of device design is increased, and miniaturization of a device becomes possible.

In the production process of the invention, subsequently to the step (A), a ceramic paste layer and a conductive paste layer are formed on the raw material substrate prepared in the step (A) to prepare a metallized ceramic substrate precursor (step (B)).

Formation of the ceramic paste layer in the step (B) is carried out by applying a ceramic paste onto the raw material substrate and then drying the paste when needed. If the raw material substrate has a conductive layer or a conductive paste layer on the surface, the ceramic paste may be applied onto such a layer.

As the ceramic paste, publicly known ceramic pastes consisting of components, such as ceramic powders, a sintering auxiliary agent, an organic binder, an organic solvent, a dispersant and a plasticizer, are employable without any restriction.

As the ceramic powder contained in the ceramic paste, publicly known powders are employable without any restriction. For example, powders of various kind of ceramics exemplified in the description of the ceramic substrate can be employed. Of these, powder of the same ceramic as that of the raw material substrate is preferably employed as the ceramic powder, from the viewpoint of adhesion to the ceramic substrate after firing. However, even by the use of ceramics of different types from each other, sufficient bonding strength can be obtained depending upon their combination. For example, even if ceramics of different types are used, high bonding strength can be obtained when the types of cation components (metal atoms or semimetal atoms) contained in the ceramics are the same as each other. For example, when the ceramic substrate is a sintered aluminum nitride substrate, aluminum nitride powders, aluminum powder or a mixture thereof can be employed.

As the sintering auxiliary agent contained in the ceramic paste, sintering auxiliary agents, which are used according to the types of the ceramic powders, are employable without any restriction. When the ceramic powder is, for example, aluminum nitride powder, rare earth element oxides such as yttrium oxide, alkaline earth metal oxides such as calcium oxide, etc. can be employed.

As the organic binder contained in the ceramic paste, publicly known organic binders are employable without any restriction. For example, acrylic resins, such as polyacrylates and polymethacrylates, cellulose-based resins, such as methyl cellulose, hydroxymethyl cellulose, nitrocellulose and cellulose acetate butyrate, vinyl group-containing resins, such as polyvinyl butyral, polyvinyl alcohol and polyvinyl chloride, hydrocarbon resins, such as polyolefin, oxygen-containing resins, such as polyethylene oxide, etc. can be employed singly or in combination of two or more kinds. Of these, acrylic resins and cellulose-based resins are preferable because they are easily dissolved in solvents and easily absorb solvents contained in the conductive paste such as a tungsten paste.

As the organic solvent contained in the ceramic paste, publicly known organic solvents are employable without any restriction. For example, toluene, ethyl acetate, terpineol, butyl carbitol acetate, texanol, etc. can be employed.

As the dispersant contained in the ceramic paste, publicly known dispersants are employable without any restriction. For example, phosphate-based dispersants, polycarboxylic acid-based dispersants, etc. can be employed.

As the plasticizer contained in the ceramic paste, publicly known plasticizers are employable without any restriction. For example, dioctyl phthalate, dibutyl phthalate, diisononyl phthalate, diisodecyl phthalate, dioctyl adipate, etc. can be employed.

The blending ratios of the raw material components in the ceramic paste are not specifically restricted, but based on 100 parts by weight of the ceramic powder, the amount of the sintering auxiliary agent is preferably in the range of 0.1 to 15 parts by weight, the amount of the organic binder is preferably in the range of 6 to 20 parts by weight, and the amount of at least one component selected from the group consisting of the organic solvent, the plasticizer and the dispersant is preferably in the range of 10 to 60 parts by weight. From the viewpoint that the effect of preventing "running" or "spreading" of the conductor paste is high, it is particularly preferable that based on 100 parts by weight of the ceramic powder, the amount of the sintering auxiliary agent is in the range of 1 to 10 parts by weight, the amount of the organic binder is in the range of 6 to 15 parts by weight, and the amount of at least one component selected from the group consisting of the organic solvent, the plasticizer and the dispersant is in the range of 15 to 50 parts by weight.

The means to prepare the ceramic paste is not specifically restricted provided that various components can be blended to obtain a paste of homogeneous composition, and for example, a publicly known kneading means, such as a three-roll mill or a planetary mixer, is adoptable.

In the production process of the invention, the ceramic paste prepared as above is applied onto the prescribed portion on the surface of the raw material substrate. The shape and the size of the ceramic paste applied are not specifically restricted provided that a conductive paste layer of a prescribed pattern can be formed thereon. However, in the case where the raw material substrate has a via hole (i.e., through hole filled with a conductor or a conductive paste) and the via hole is electrically connected to a metallization layer to be formed, it is necessary that the ceramic paste should not be applied onto the exposed surface of the conductor or the conductive paste. Further, a ceramic paste layer does not necessarily have to be formed under all the conductive paste layers, and a structure in which a ceramic paste layer is formed under only a conductive paste layer of a specific pattern (e.g., layer that becomes a wiring of a fine pattern or a marker) may be taken. Such application of the ceramic paste can be carried out by a publicly known method, such as screen printing, calendar printing or pad printing.

The thickness of the ceramic paste layer to be formed is not specifically restricted, but from the viewpoints of effect of preventing "running" or "spreading" of the conductor paste layer and productivity, the thickness thereof is in the range of preferably 1 to 2000 $\mu$m, particularly preferably 1 to 50 $\mu$m, most preferably 3 to 15 $\mu$m. If the ceramic paste layer is too thin, the effect of preventing running or spreading of the conductive paste applied is not obtained sufficiently. If the ceramic paste layer is too thick, an unnecessary amount of the ceramic paste is used, and this is uneconomical. Moreover, there is a possibility of nonuniform thickness or occurrence of strain after firing. For such reasons, the thickness of the ceramic paste layer positioned just under the conductive paste layer that is formed in order to form a conductive layer of a fine pattern having, for example, a gap (space) between conductor lines (wirings) of 50 to 10 $\mu$m, preferably 30 to 15 $\mu$m, is preferably in the range 1 to 50 $\mu$m, particularly 3 to 15 $\mu$m.

In the production process of the invention, it is desirable to dry the resulting ceramic paste layer before the conductive paste layer is formed. By vaporizing a solvent contained in the ceramic paste to remove it, a solvent contained in the conductive paste applied onto the ceramic paste tends to be absorbed more, and the effect of preventing "running" or "spreading" of the conductive paste layer is enhanced. The drying can be preferably carried out by maintaining the substrate in air at a temperature of 40 to 150°C for 1 to 30 minutes.

Formation of the conductive paste layer in the step (B) is carried out by applying a conductive paste in the shape of a prescribed pattern onto the ceramic paste layer, which has been formed as above on the raw material substrate and subjected to drying when needed, and then drying the conductive paste when needed. The ceramic paste layer present under the conductive paste layer absorbs an organic solvent contained in the conductive paste, so that running or spreading of the conductive paste thus applied does not occur.

According to the production process of the invention including the step of forming the conductive paste layer, therefore, a metallized ceramic substrate having a conductive layer (metallization layer) of a fine pattern having, for example, a gap (space) between conductor lines (wirings) of 80 to 10 $\mu$m, preferably 50 to 10 $\mu$m,

most preferably 30 to 15 $\mu$m, and further, a metallized ceramic substrate having a metallization layer of a fine pattern having "line and space" of preferably not more than 80/80 $\mu$m, more preferably not more than 50/50 $\mu$m, particularly preferably not more than 30/30 $\mu$m, can be produced in a high yield. In the case where such a metallized ceramic substrate is used for a circuit board, the circuit board obtained has a fine pattern, is free from a short circuit and has high reliability. The expression "line and space of X/Y $\mu$m" means that plural conductor lines (wirings) each having a line width of X $\mu$m can be formed with substantially maintaining a space of Y $\mu$m.

The metallization layer is sometimes formed not only as a wiring but also as a recognition marker (alignment mark for mounting) of the metallized substrate, and when a recognition marker is formed by the process of the invention, the shape of the marker can be recognized clearly, and this provides a merit that the ratio of wrong recognition of markers is low.

As the conductive paste for use in the invention, publicly known conductive pastes consisting of components, such as metal powders, an organic binder, an organic solvent, a dispersant and a plasticizer, are employable without any restriction. In the conductive paste, ceramic powders of the same kind as that of the ceramic powders contained in the aforesaid ceramic paste are preferably contained. If ceramic powders of the same kind as that of the ceramic powders of the ceramic paste are contained in the conductive paste, adhesion between them after firing is enhanced.

Examples of the metal powders contained in the conductive paste include powders of metals such as tungsten, molybdenum, gold, silver and copper. Of these, powders of high-melting point metals having resistance to high temperatures in the firing, such as tungsten and molybdenum, are particularly preferable.

As the organic binder contained in the conductive paste, publicly known organic binders are employable without any restriction. For example, acrylic resins, such as polyacrylates and polymethacrylates, cellulose-based resins, such as methyl cellulose, hydroxymethyl cellulose, nitrocellulose and cellulose acetate butyrate, vinyl group-containing resins, such as polyvinyl butyral, polyvinyl alcohol and polyvinyl chloride, hydrocarbon resins, such as polyolefin, oxygen-containing resins, such as polyethylene oxide, etc. can be employed singly or in combination of two or more kinds.

As the organic solvent contained in the conductive paste, publicly known organic solvents are employable without any restriction. For example, toluene, ethyl acetate, terpineol, butyl carbitol acetate, texanol, etc. can be employed, and it is preferable to select a solvent that easily dissolves the resin of the ceramic paste. It is more preferable to select organic binders of the same kind and organic solvents of the same kind for the ceramic paste and the conductive paste because compatibility of the organic binders and compatibility of the organic solvents become excellent.

As the dispersant contained in the conductive paste, publicly known dispersants are employable without any restriction. For example, phosphate-based dispersants, polycarboxylic acid-based dispersants, etc. can be employed.
As the plasticizer contained in the conductive paste, publicly known plasticizers are employable without any restriction. For example, dioctyl phthalate, dibutyl phthalate, diisononyl phthalate, diisodecyl phthalate, dioctyl adipate, etc. can be employed.

Application of the conductive paste can be carried out by a publicly known method, such as screen printing, calendar printing or pad printing. Although the thickness of the conductive paste layer formed is not specifically restricted, it is in the range of generally 1 to 100 $\mu$m, preferably about 5 to 30 $\mu$m.
In the production process of the invention, the metallized ceramic substrate precursor prepared as above is fired (step (C)), whereby a metallized ceramic substrate that is the product of the invention is obtained. Prior to firing, degreasing may as well be carried out, when needed.

Degreasing is carried out by heat-treating the metallized ceramic substrate precursor in an oxidizing gas such as oxygen or air, a reducing gas such as hydrogen, an inert gas such as argon or nitrogen, carbon dioxide, a mixed gas of these gases, or a humid gas atmosphere containing water vapors. As the heat treatment conditions, the temperature is properly selected from the range of 250°C to 1200°C and the retention time is properly selected from the range of 1 minute to 1000 minutes according to the type and the amount of the organic component contained in the metallized ceramic substrate precursor.

As the conditions for firing that is carried out subsequently to the degreasing treatment, usually adopted conditions according to the type of the ceramic paste used (more specifically, type of the ceramic powder used as the raw material) are properly adopted. For example, when the ceramic powders contained in the ceramic paste layer are powders of an aluminum nitride-based ceramic, firing is carried out at a temperature of 1600 to 2000°C, preferably 1700 to 1850°C, for 1 to 20 hours, preferably 2 to 10 hours. As the atmosphere for the firing, an atmosphere of a non-oxidizing gas such as a nitrogen gas is used, and the firing is carried out at ordinary pressure.

In the metallized ceramic substrate obtained in the production process of the invention, the pattern of the metallization layer is clear, and when the pattern is, for example, a circuit pattern, the metallized ceramic substrate has an excellent feature that a short circuit does not occur between lines even if the pattern is a fine pattern having line and space of not more than 80/80 $\mu$m, preferably not more than 50/50 $\mu$m, more preferably not more than 30/30 $\mu$m. In the metallized substrate obtained by the conventional post firing process or co-firing process, there are limitations on fining of a conductive pattern, and if fining of a conductive pattern is carried out daringly, a problem of yield occurs. Therefore, the process of the invention is excellent in that the above substrate can be efficiently produced at a low cost.

In the production process of the invention, a substrate constituted of ceramic grains having a mean grain diameter of preferably 0.5 to 20 $\mu$m (more preferably 1 to 15 $\mu$m) is used as the sintered ceramic substrate of the raw material substrate, as previously described. A metallized ceramic substrate produced by using such a sintered ceramic substrate and by using a ceramic paste prepared using a ceramic powder having a mean grain diameter of 0.1 to 15 $\mu$m (preferably 0.5 to 5 $\mu$m) in the production process of the invention, preferably a metallized ceramic substrate obtained by forming at least one ceramic paste layer having a thickness of 1 to 50 $\mu$m in the step (B), is a novel metallized ceramic substrate having a structural feature which is not observed in a metallized ceramic substrate produced by the conventional co-firing process or post firing process.

That is to say, the above-mentioned novel substrate is a metallized ceramic substrate in which a conductive layer is bonded to a sintered ceramic substrate through a "layer of a sintered ceramic" of the same kind as that of the ceramic for forming the substrate, and has a feature that the mean grain diameter of the ceramic grains to constitute the "sintered ceramic layer" is 10 to 80% of the mean grain diameter of the ceramic grains to constitute the sintered ceramic substrate. When the metallized ceramic substrate has plural "sintered ceramic layers", the mean grain diameter of the ceramic grains to constitute at least one of the layers has to be 10 to 80% of the mean grain diameter of the ceramic grains to constitute the sintered ceramic substrate. In general, the mean grain diameter of the ceramic grains to constitute the "sintered ceramic layer" depends upon the thickness of the ceramic paste layer that is a precursor of the sintered ceramic layer (accordingly it depends upon the thickness of the sintered ceramic layer), and if the thickness of the ceramic paste layer is not more than 50 $\mu$m, the above requirements are satisfied.

The "sintered ceramic layer" used herein is a layer formed by sintering the ceramic paste layer formed on the raw material substrate in the production process of the invention, and the thickness thereof depends upon the thickness of the ceramic paste layer. Because shrinkage takes place in the sintering, the thickness of the sintered body layer usually becomes 20 to 80% of the thickness of the ceramic paste layer. In order to obtain a sintered ceramic layer of a desired thickness, therefore, the thickness of the ceramic paste layer is properly controlled. As previously described, the thickness of the ceramic paste layer positioned just under the conductive paste layer that is formed in order to form a conductive layer of a fine pattern having a gap (space) between conductive lines (wirings) of 50 to 10 $\mu$m, preferably 30 to 15 $\mu$m, is in the range of preferably 1 to 50 $\mu$m, particularly preferably 3 to 15 $\mu$m, so that the thickness of the sintered ceramic layer positioned just under the conductive layer of such a fine pattern is in the range of preferably 0.2 to 40 $\mu$m, particularly preferably 0.6 to 12 $\mu$m.

In the case where the conductive layer is made to have multi-layer construction as described later, control of the thickness of a sintered ceramic layer present between the conductive layers becomes important. That is to say, if the thickness of the sintered ceramic layer is too large, this thickness hinders mounting of a chip onto the conductive layer, or the whole thickness of a device becomes large. If the thickness of the sintered ceramic layer is too small, an influence is sometimes exerted on the reliability of a device. From these viewpoints, it is desirable to adjust the thickness of the finally obtained sintered ceramic layer to preferably 1 to 100 $\mu$m, more preferably about 10 to 800 $\mu$m.

The mean diameter D ($\mu$m) of the ceramic grains to constitute the sintered ceramic can be determined in the following manner using a Code method. First, a scanning electron microphotograph of a section of the sintered ceramic is taken. The magnification used herein is determined as follows. That is to say, on the microphotograph, an arbitrary linear line of a specific length L (mm) (usually the same length as the width of the microphotograph) is drawn in the perpendicular direction (in case of a sintered ceramic in the form of a plate, direction that is parallel to its main surface) to the thickness direction of the sintered ceramic, and magnification is determined so that the number of intersecting points of the liner line and grain boundaries of the ceramic grains should become 10 to 50 (usually 1000 to 5000 magnifications). From the magnification, a length U (mm) on the microphotograph corresponding to the actual length 1 ($\mu$m) is determined. Then, on the microphotograph, n liner lines of a length L that are parallel to the above linear line are drawn at given intervals (usually 3 to 7 mm, particularly 5 mm). The number n of the linear lines is determined so that the total number $\varepsilon$ of the intersecting points of all the linear lines and grain boundaries of the ceramic grains should become 100 to 300. After n linear lines are drawn, the intersecting points of each linear line and the grain boundaries are marked, and the total number $\varepsilon$ of the marks is determined. Then, the mean diameter D can be calculated from the following formula.

$$D = (1.57 \times L \times n)/(U \times \varepsilon)$$

The metallized ceramic substrate which can be obtained by the production process of the invention, particularly a metallized ceramic substrate having a conductive layer (metallization layer) of a fine pattern having a gap (space) between conductor lines (wirings) of 80 to 10 $\mu$m, preferably 50 to 10 $\mu$m, most preferably 30 to 15 $\mu$m, has an excellent feature that the substrate can be easily produced in a high yield (for example, by adopting the process of the invention) in spite that it has a fine pattern, said feature being not observed in a conventional metallized ceramic substrate.

According to the production process of the invention, therefore, the degree of freedom of wiring design is greatly increased, restrictions on the device design are reduced, and miniaturization of a device itself becomes possible.

According to the production process of the invention, further, formation of multi-layer construction of a conductive layer is easily made. Formation of multi-layer construction of a conductive layer is carried out by any of the following two methods. That is to say, a method (first method) in which formation of a ceramic paste layer and formation of a conductive paste layer in the step (B) are alternately repeated plural times, or a method (second method) in which a metallized ceramic substrate obtained by the production process of the invention is used as a raw material substrate is available. The "plural times" in the first method includes also an embodiment in which only formation of a ceramic paste layer is carried out twice but formation of a conductive paste layer is carried out once. In such an embodiment, a sintered ceramic layer can be formed as the topmost layer. In the case where a conductive layer composed of a high-melting point metal such as tungsten or molybdenum is cut in the cutting process of the resulting metallized substrate usually using a dicing blade, peeling of the conductive layer sometimes occurs in the cutting process. However, by forming a sintered ceramic layer on the predetermined cutting line and by cutting this portion, such peeling can be prevented. Further, by forming a sintered ceramic layer in the shape of a frame as the topmost layer, alignment of an element or a part to be mounted on the metallized substrate becomes possible, and besides, by forming the frame-like layer at a higher position than the position of the mounted part, protection of the mounted part becomes possible. The thickness of the sintered ceramic layer formed as the topmost layer is desirably adjusted to preferably 1 to 1000 $\mu$m, more preferably about 10 to 800 $\mu$m.

By allowing the production process of the invention to further include a step of forming a ceramic paste layer on the conductive layer of the metallized ceramic substrate obtained in the step (C) and a step of firing the metallized ceramic substrate having a ceramic layer on the surface obtained in the above step, a sintered ceramic layer can be formed as the topmost layer, and the same effects as above can be obtained.

Formation of multi-layer construction of a conductive layer by the production process of the invention is described below giving some specific examples though the formation is not limited to the examples.

Examples, thickness, etc. of the ceramic substrate, the ceramic paste, the conductive paste, etc. are as previously described.

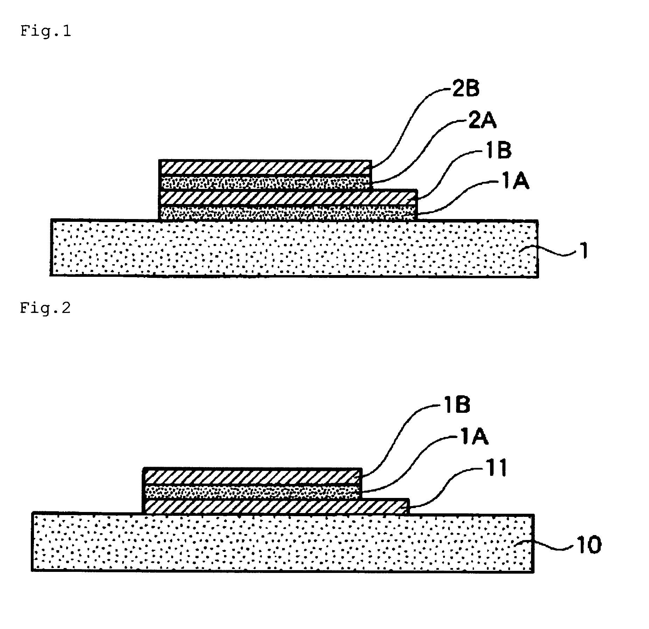

In an example shown in Fig. 1, a ceramic paste 1A is applied in the shape of a prescribed pattern onto a ceramic substrate 1, and if necessary, it is dried. Then, a conductive paste 1B is applied in the shape of a prescribed pattern onto the ceramic paste 1A, and if necessary, it is dried. Thereafter, on the conductive paste 1B, a ceramic paste 2A and a conductive paste 2B are provided successively, and they are fired, whereby a multilayer metallized substrate having a laminated structure consisting of two conductive layers and two sintered ceramic layers is obtained. It is also possible that after the conductive paste 1B is provided, it is fired, and on the resulting conductive layer, a ceramic paste 2A and a conductive paste 2B are provided successively and then fired. In this case, the ceramic substrate obtained by successively providing the ceramic paste 1A and the ceramic paste 1B on the surface and firing them becomes a raw material substrate on which a ceramic paste 2A is to be provided.

As previously described, a metallized substrate having a conductive layer which has been formed in advance by a conventional process can be used as a raw material substrate on which a ceramic paste 1A is to be provided.

In an example shown in Fig. 2, a metallized substrate 10 having a conductive layer, 11 which has been formed in advance, is used, and onto the conductive layer 11, a ceramic paste 1A is applied in the shape of a prescribed pattern, and if necessary, it is dried. Then, onto the ceramic paste 1A, a conductive paste 1B is applied in the shape of a prescribed pattern, and if necessary, it is dried. Thereafter, firing is carried out, whereby a multi-layer metallized substrate having a laminated structure consisting of two conductive layers and one sintered ceramic layer is obtained.

In the example shown in Fig. 2, an unfired conductive paste layer may be used instead of the conductive layer 11. If a conductive paste layer is formed directly on the ceramic substrate, "running" or "spreading" of the paste occurs, as previously described, and it is difficult to form a fine pattern. However, when the conductive layer as the lowest layer is not required to be a fine pattern in the device design, the conductive paste layer may be formed directly on the ceramic substrate.

In the present invention, a via hole to electrically connect conductive layers to each other can be easily provided. In this case, a pillar-like conductive paste has only to be provided in a part of a ceramic paste layer present between conductive paste layers (or between a conductive layer and a conductive paste layer).

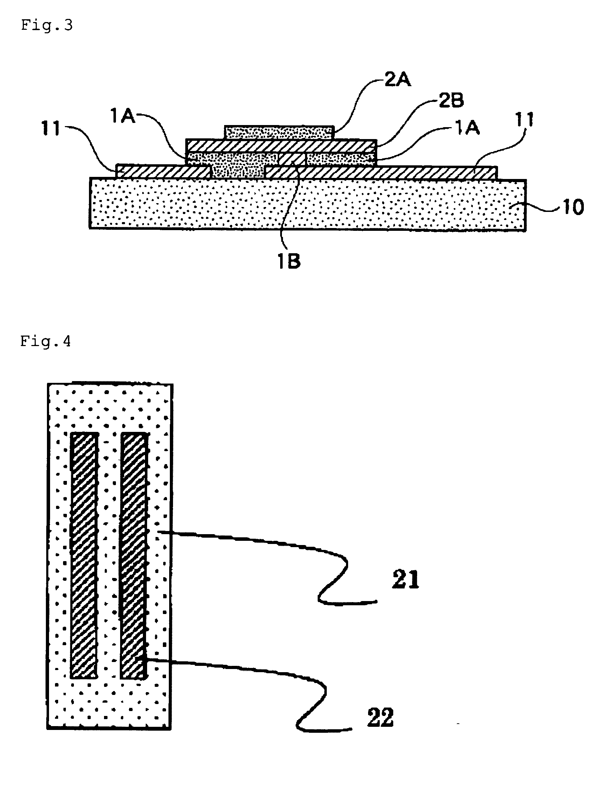

In Fig. 3, an example in which conductive layers are allowed to have continuity across them and a sintered ceramic layer is formed as the topmost layer is shown. In this example, a metallized substrate 10 having a conductive layer 11 which has been formed in advance is used, but as previously described, the conductive layer 11 may be a conductive paste layer. First, at the prescribed position of the conductive layer 11, a pillar-like conductive paste layer 1B is formed. Then, a ceramic paste layer 1A having such a thickness that the upper surface of the ceramic paste layer and the upper surface of the conductive paste layer 1B coincide with each other is formed. That is to say, on the conductive layer 11, the thickness of the ceramic paste layer 1A is the same as the thickness of the conductive paste layer 1B, while on the ceramic substrate 10, the thickness of the ceramic paste layer 1A is the same as the total thickness of the conductive layer 11 and the conductive paste layer 1B. The ceramic paste layer and the conductive paste layer shrink by firing, so that it is desirable to properly determine the thickness of the ceramic paste layer and the thickness of the conductive paste layer taking final thickness thereof into account. In order to secure continuity, it is desirable to slightly protrude the conductive layer from the surface of the sintered ceramic layer that is formed by firing the ceramic paste layer 1A. Therefore, the thickness of the ceramic paste layer and the thickness of the conductive paste layer are determined so that the thickness of the conductive layer that is formed by firing the conductive paste layer 1B should be a little larger than the thickness of the sintered ceramic layer that is formed by firing the ceramic paste layer 1A.

Subsequently, onto the ceramic paste 1A, a conductive paste 2B is applied in the shape of a prescribed pattern, and if necessary, it is dried. Thereafter, a ceramic paste 2A is provided on the conductive paste 2B, and then firing is carried out, whereby a multi-layer metallized substrate having a laminated structure including two conductive layers having continuity across them is obtained. It is also possible that after the conductive paste 2B is provided, it is fired, and on the resulting conductive layer, a ceramic paste 2A is provided and then fired.

EXAMPLES

The present invention is further described with reference to the following examples, but it should be construed that the invention is in no way limited to those examples.

Example 1

On a surface of a raw material substrate made of a sintered aluminum nitride substrate obtained by mixing aluminum nitride powders having a mean grain diameter of 1.5 $\mu$m with yttrium oxide as a sintering auxiliary agent and sintering them, an aluminum nitride paste obtained by kneading 100 parts by weight of aluminum nitride powders having a mean grain diameter of 1.5 $\mu$m, 5 parts by weight of yttrium oxide powders having a mean grain diameter of 0.5 $\mu$m, 9 parts by weight of ethyl cellulose and 40 parts by weight of terpineol and adjusting the viscosity at 25°C to 3500 P was screen-printed to form 100 aluminum nitride paste layers 21 of patterns (thickness: 10 $\mu$m) each having a width of 200 $\mu$m and a length of 1 mm as shown in Fig. 4 and to form a T-shaped pattern having a wiring width of 200 $\mu$m, and they

were dried at 80°C for 5 minutes.

Then, 100 parts by weight of tungsten having a mean grain diameter of 0.8 μm, 5 parts by weight of aluminum nitride powders having a mean grain diameter of 1.5 μm, 0.3 part by weight of yttrium oxide, 2 parts by weight of ethyl cellulose and 10 parts by weight of terpineol were kneaded to prepare a conductive paste. Thereafter, using this conductive paste, 2 conductive paste layers 22 of patterns (thickness: 15 μm) each having a width of 50 μm and a length of 500 μm as shown in Fig. 4 were formed on each of the aluminum paste layers 21 by screen printing, and a T-shaped conductive paste layer having a wiring width of 100 μm was formed on the aluminum nitride paste layer of T-shaped pattern, followed by drying. In the pattern shown in Fig. 4, the gap (space) between the two linear conductive paste layers 22 was 30 μm.

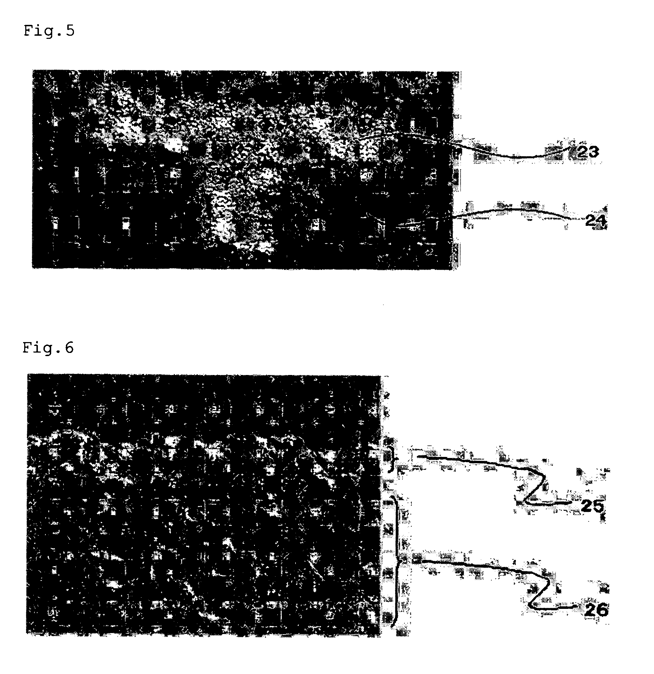

The substrate obtained as above was fired at 1800°C for 4 hours in a nitrogen gas to obtain a metallized substrate. The surface of the resulting substrate where the T-shaped metallization layer had been formed was observed by a video microscope. The resulting microphotograph is shown in Fig. 5. It can be seen that a clear metallization pattern 23 having little deformation of pattern due to "spreading" or the like was formed on the aluminum nitride paste layer 24 after sintering, as shown in Fig. 5. Then, resistance between the wirings shown in Fig. 4 was confirmed to examine whether there was a short circuit between the metallization wirings or not, and as a result, a short circuit was not observed.

Further, a cutout section of a portion of the resulting substrate where a sintering product layer of the aluminum nitride paste layer had been bonded to the raw material substrate but a metallization layer had not been formed thereon was observed by a scanning electron microscope. The resulting microphotograph is shown in Fig. 6. It can be seen from Fig. 6 that the thickness of the layer 25 formed by sintering the aluminum nitride paste layer was 5 μm, the mean grain diameter of the aluminum nitride grains to constitute the layer 25 was 2.1 μm (determined by Code method), and the mean grain diameter of the aluminum nitride grains to constitute the sintered aluminum nitride substrate 26 used as a raw material substrate was 5.4 μm (determined by Code method).

Comparative Example 1

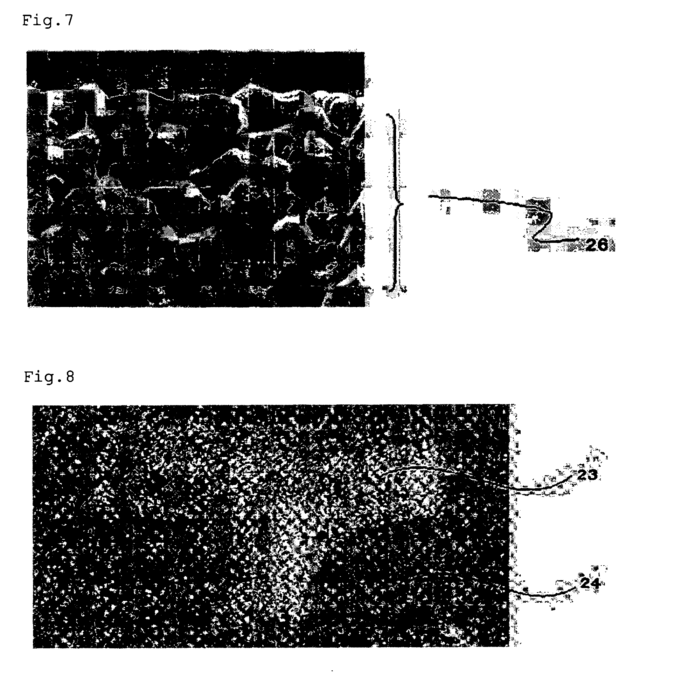

A metallized substrate was prepared in the same manner as in Example 1, except that the aluminum nitride paste layer was not formed. Then, the same evaluation as in Example 1 was carried out. A cutout section of a portion of the resulting substrate where a metallization layer was not formed is shown in Fig. 7. As shown in Fig. 8, deformation of the T-shaped metallization pattern 23 derived from "spreading" or the like was observed, and a short circuit between wirings was observed in 83 patterns of 100 patterns shown in Fig. 4.

INDUSTRIAL APPLICABILITY

If the production process of the invention is used, running or spreading of a conductive paste does not occur in the formation of a conductive paste layer on a ceramic substrate. Accordingly, a ceramic circuit board having a high degree of freedom of wiring design and high reliability and a ceramic substrate having a fine circuit pattern can be produced.

**Claims**

1. A process for producing a metallized ceramic substrate, comprising:

   a step (A) of preparing a raw material substrate comprising a ceramic substrate which may have on its surface a conductive layer or a conductor paste layer,
   a step (B) of preparing a metallized ceramic substrate precursor, comprising a step of forming a ceramic paste layer on the raw material substrate and a step of forming a conductive paste layer on the ceramic paste layer, and
   a step (C) of firing the metallized ceramic substrate precursor obtained in the previous step.

2. The process as claimed in claim 1, further comprising a step of forming a ceramic paste layer on a conductive layer of the metallized ceramic substrate obtained in the step (C) and a step of firing the metallized ceramic substrate having on its surface the ceramic paste layer obtained in the above step.

3. The process as claimed in claim 1 or 2, wherein in the step (B), formation of a ceramic paste layer and formation of a conductive paste layer are alternately repeated plural times.

4. The process as claimed in any one of claims 1 to 3, wherein the metallized ceramic substrate obtained in the process of any one of claims 1 to 3 is used as a raw material substrate.

5. The process as claimed in any one of claims 2 to 4, wherein the ceramic paste layer formed on the conductive paste layer or a conductive layer obtained by firing the conductive paste layer is a ceramic paste layer which covers a part of said base layer and has a thickness of 1 to 2000 μm.

6. The process as claimed in any one of claims 1 to 5, wherein the ceramic substrate comprises aluminum nitride.

7. The process as claimed in any one of claims 1 to 6, wherein the ceramic paste layer comprises an aluminum nitride-based ceramic.

8. The process as claimed in any one of claims 1 to 7, wherein the conductive paste layer comprises tungsten or molybdenum.

9. A metallized ceramic substrate obtained by the process of any one of claims 1 to 8.

10. A metallized ceramic substrate having a laminated structure comprising at least one conductive layer and at least one sintered ceramic layer on a sintered ceramic substrate, wherein the topmost layer of the laminated structure is a sintered ceramic layer which covers at least a part of a conductive layer that is a layer under the sintered ceramic layer and has a thickness of 1 to 1000 $\mu$m.

11. A metallized ceramic substrate having a laminated structure comprising at least one conductive layer and at least one sintered ceramic layer on a sintered ceramic substrate, wherein the sintered ceramic layer to form the laminated structure comprises a sintered body of a ceramic of the same kind as that of the ceramic to constitute the sintered ceramic substrate and the mean grain diameter of ceramic grains to constitute the sintered ceramic layer is 10 to 80% of the mean grain diameter of ceramic grains to constitute the sintered ceramic substrate.

Fig.1

Fig.2

Fig.3

Fig.4

Fig.5

Fig.6

Fig.7

Fig.8

## INTERNATIONAL SEARCH REPORT

| International application No. |
| --- |
| PCT/JP2005/022856 |

A. CLASSIFICATION OF SUBJECT MATTER
*C04B41/90*(2006.01), *H05K3/12*(2006.01)

According to International Patent Classification (IPC) or to both national classification and IPC

B. FIELDS SEARCHED

Minimum documentation searched (classification system followed by classification symbols)
C04B41/90, H05K3/00-3/46

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2000-138428 A  (Kyocera Corp.),<br>16 May, 2000 (16.05.00),<br>Par. Nos. [0002], [0044], [0047], [0051],<br>[0052]<br>(Family: none) | 1,4,5,8-11<br>6,7 |
| X<br>Y | JP 9-221375 A  (Sumitomo Metal Industries,<br>Ltd.),<br>26 August, 1997 (26.08.97),<br>Claim 2; Par. Nos. [0002], [0022], [0037]<br>(Family: none) | 1,4,5,8-11<br>6,7 |
| Y | JP 2002-187776 A  (Toshiba Corp.),<br>05 July, 2002 (05.07.02),<br>Claims<br>(Family: none) | 6,7 |

| ☒ Further documents are listed in the continuation of Box C. | ☐ See patent family annex. |
| --- | --- |

| | |
| --- | --- |
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>01 February, 2006 (01.02.06) | Date of mailing of the international search report<br>14 February, 2006 (14.02.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
|---|
| PCT/JP2005/022856 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-335508 A (NGK Spark Plug Co., Ltd.), 25 November, 2004 (25.11.04), Par. No. [0001] (Family: none) | 2,3 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H081996239286 A